# EUROPEAN PATENT APPLICATION

(11) **EP 4 815 671 A1**
(43) Date of publication of application: **30.09.2026**
(21) Application number: 26164266.4
(22) Date of filing: 12.03.2026
(51) Int. Cl.: H10D 64/01, H10D 8/01, H10D 64/62, H10P 34/42, H10D 8/60, H10D 62/10, H10D 62/832

(54) **METHOD OF STRESS RELEASE IN SILICON CARBIDE DEVICES**

(30) Priority: 25.03.2025 IT 202500006096
(71) Applicant: STMicroelectronics International N.V., 1228 Plan-les-Ouates, Geneva (CH)
(72) Inventor: RASCUNA', Simone, 20864 Agrate Brianza (MB) (IT); BADALA', Paolo, 20864 Agrate Brianza (MB) (IT); BELLOCCHI, Gabriele, 20864 Agrate Brianza (MB) (IT); BASSI, Anna, 20864 Agrate Brianza (MB) (IT); LANDI, Antonio, 20864 Agrate Brianza (MB) (IT); BOSCAGLIA, Massimo, 20864 Agrate Brianza (MB) (IT); MASSIMINO, Maurizio, 20864 Agrate Brianza (MB) (IT)
(74) Representative: Studio Torta S.p.A.

(57) **Abstract**

Method of manufacturing an electronic device, comprising the steps of providing a substrate (2) of silicon carbide, in particular 4H-SiC, having a first surface (2a) and a second surface (2b') opposite to the first surface; depositing on the second surface a first metal layer (10) having a first thickness; heating selective portions of the first metal layer by means of a first laser beam (12); depositing, in direct physical contact with the first metal layer, a second metal layer (14) having a second thickness greater than the first thickness; and heating selective portions of the second metal layer by means of a second laser beam (16).

## Description

### TECHNICAL FIELD

The present invention relates to a method of manufacturing an electronic device, and to the electronic device thus manufactured. In particular, the invention applies to electronic devices made of silicon carbide, even more in particular to the 4H-SiC polytype.

### STATE OF THE ART

Thinning of silicon carbide (SiC) wafers, used as substrates on which power electronic devices are manufactured, is essential for providing new-generation devices. In fact, by reducing the thickness of the silicon carbide wafers, in particular of the 4H-SiC polytype, the power dissipation of such electronic devices may be significantly reduced.

During a manufacturing process, a 4H-SiC wafer comprising on one first side thereof one or more electronic devices (e.g. diodes or transistors) is thinned, through a per-se-known process of thickness rectification or reduction, known as a "grinding" process, carried out on a second side of the 4H-SiC wafer opposite to the first side.

Following the grinding process, a metal contact is formed on the second side of the 4H-SiC wafer, for example made of nickel (Ni) or titanium (Ti). Typically, this metal contact has a thickness equal to or greater than 50 nm.

Following the formation of the metal contact, a laser annealing step of the metal contact is performed, to form a silicide layer, for example of nickel silicide (NiSi), between the metal contact and the 4H-SiC wafer. The formation of the silicide layer, performed by laser annealing, is essential for providing a good ohmic contact between the metal contact and the second side of the 4H-SiC wafer, without damaging the electronic device present on the first side of the same wafer.

However, following the grinding process, the mechanical integrity of the 4H-SiC wafer is significantly compromised. In fact, following this process, the 4H-SiC wafer undergoes deformations such as bow and warpage. These deformations remain even following the formation of the metal contact and the laser annealing step.

Under certain conditions, these deformations may critically hinder subsequent processing steps, leading to complications such as for example increased difficulty in handling the 4H-SiC wafer, a risk of breakdown of the 4H-SiC wafer, a decrease in the yield of the manufacturing process, and possible damage to the machinery used in the manufacturing process.

Furthermore, the demand for increasingly thinner 4H-SiC wafers (e.g. 4H-SiC wafers with thicknesses comprised between 50 µm and 150 µm) and with increasingly larger diameters, for example with diameters of 300 mm or more, exacerbates these issues.

Document US 2020/044031 A1 describes a semiconductor power device that uses a silicon carbide (SiC) layer on which the active component is made. On the opposite side, an ohmic contact is formed in nickel silicide (NiSix), organized into three regions with different precipitates of unreacted carbon and refractory metal carbides. A layer of weldable metal is then applied to this multilayer.

Document US 2006/273323 A1 relates to a semiconductor device with a SiC substrate and a method for its manufacture.

Document US 2021/143006 A1 relates to power transistors using silicon carbide.

However, the above-mentioned problems are not solved.

A need is therefore felt to provide a method of manufacturing silicon carbide wafers, in particular of the 4H-SiC polytype, such as to overcome the drawbacks of the prior art.

### SUMMARY

The present invention relates to a method of manufacturing an electronic device and to the electronic device thereof, as defined in the attached claims.

### BRIEF DESCRIPTION OF THE DRAWINGS

For a better understanding of the present invention, some embodiments thereof are now described, purely by way of non-limiting example, with reference to the attached drawings, wherein:
- Figures 1-7 illustrate, in a lateral sectional view, steps of a manufacturing process of a silicon carbide wafer;
- Figure 8 illustrates, in a lateral sectional view, an electronic device accommodated on the silicon carbide wafer manufactured by the manufacturing process of Figures 1-7; and
- Figures 9A-9H illustrate, in plan view, distribution patterns of energy density supplied by a laser on a back face of the silicon carbide wafer of Figures 1-7.

### DESCRIPTION OF EMBODIMENTS OF THE INVENTION

According to one aspect of the present invention, a manufacturing process of a silicon carbide (SiC) wafer, in particular of the 4H-SiC polytype, is described.

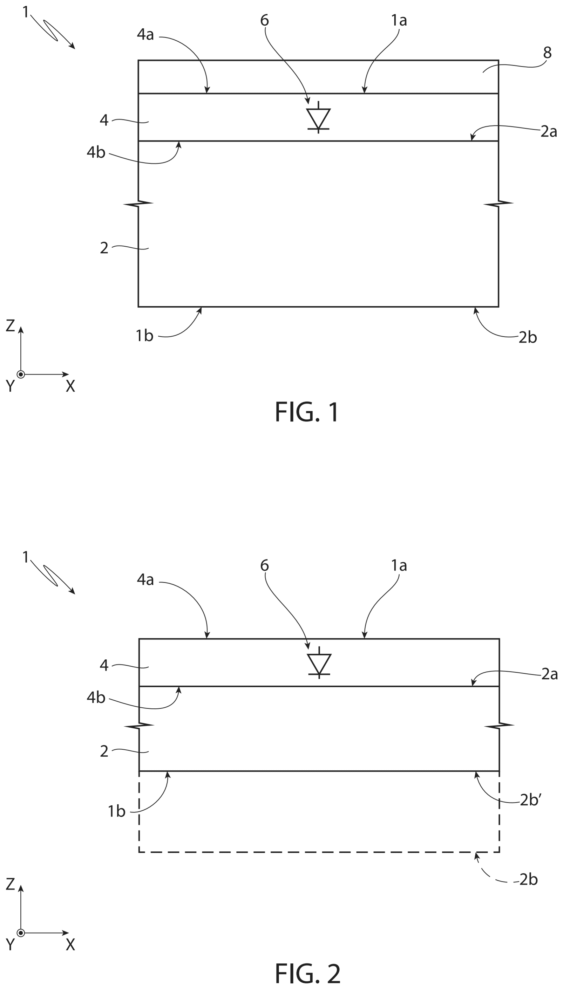

Figures 1-7 illustrate steps of a manufacturing process of a wafer 1 of silicon carbide, in particular of the 4H-SiC polytype. Figures 1-7 are represented in a triaxial system of axes X, Y, Z orthogonal to each other, in lateral section on the XZ plane.

With reference to Figure 1, the wafer 1 includes a substrate 2, having an upper surface 2a on which one or more layers 4 extend, which hereinafter will be referred to as the "layer stack" 4.

In detail, the layer stack 4 has a lower surface 4b extending in contact with the upper surface 2a of the substrate 2 and an upper surface 4a thereof opposite to the lower surface 4b along the Z-axis. The upper surface 4a of the layer stack 4 forms a front face 1a of the wafer 1. The substrate 2 has a lower surface 2b opposite to the upper surface 2a along the Z-axis, and forming a back face 1b of the wafer 1.

The substrate 2 is of silicon carbide, in particular of the 4H-SiC polytype, and has a dopant concentration having a first electrical conductivity, for example of the N-type, comprised for example between 11x10¹⁸ at/cm³ and 1x10²² at/cm³. In particular, the substrate 2 has an electrical resistivity comprised, for example, between 5 mΩ·cm and 40 mΩ·cm.

The substrate 2 has a thickness along the Z-axis, in particular in case the wafer 1 has a diameter of 300 mm, comprised for example between 300 µm and 600 µm, in particular equal to 350 µm.

In an illustrative and non-limiting manner, the wafer 1 also includes at least one electronic device 6 of a type known per se, for example a diode, illustrated only schematically in Figures 1-7, formed at least in part in the layer stack 4. In particular, the layer stack 4 includes a plurality of layers of a respective semiconductor, conductor or dielectric/insulating material.

With reference to Figure 1, according to a step of the method described herein, a protective layer 8, for example an adhesive tape, is applied on the front face 1a of the wafer 1 to protect the electronic device 6 and support the wafer 1 during subsequent processing steps of the wafer 1.

With reference to Figure 2, a grinding step is performed on the back face 1b of the wafer 1, to reduce the thickness of the wafer 1, in particular by thinning the substrate 2. The grinding step includes for example, in a manner known per se, a mechanical / chemical thinning step (e.g., including CMP - "Chemical Mechanical Polishing") of the substrate 2, removing material from the lower surface 2b of the substrate 2.

In detail, the thickness of the substrate 2 is reduced to a final thickness, along the Z-axis, comprised between 50 µm and 150 µm, for example equal to 100 µm. The substrate 2 thus exposes a new lower surface 2b', defining the back face 1b of the wafer 1.

The protective layer 8 is then removed.

At the end of the grinding step, the wafer 1 is typically deformed (non-planar), with a deformation that may be asymmetric (in plan view, the deformation of the wafer 1 along directions orthogonal to each other, X-Y, is not symmetric).

The deformation of the wafer 1 is caused by a mechanical stress accumulated during the grinding step and due to the introduction of defects in the crystal lattice of the 4H-SiC of the substrate 2, in particular in proximity to the lower surface 2b' of the substrate 2. In particular, the grinding process introduces damage to the surface and to a layer underlying the surface, observable by AFM ("Atomic Force Microscopy") analysis and TEM ("Transmission Electron Microscopy") analysis in section, as reported in P. Badalà, et al. "Electrical and structural properties of ohmic contacts of SiC diodes fabricated on thin wafers", Solid State Phenomena, 359 (2024) 97-103, and in P. Badalà, et al. "Effects of roughness variation on the electrical and structural properties of Ni silicide ohmic contacts formed by UV laser annealing" presented at the European Materials Research Society Spring Meeting, Strasbourg, 2023.

For example, in case the wafer 1 has a diameter of 300 mm in the XY plane, the wafer 1 may have a deviation from planarity, along the X-axis, for example equal to 2.0 mm, and a deviation from planarity, along the Y-axis, for example equal to 0.1 mm.

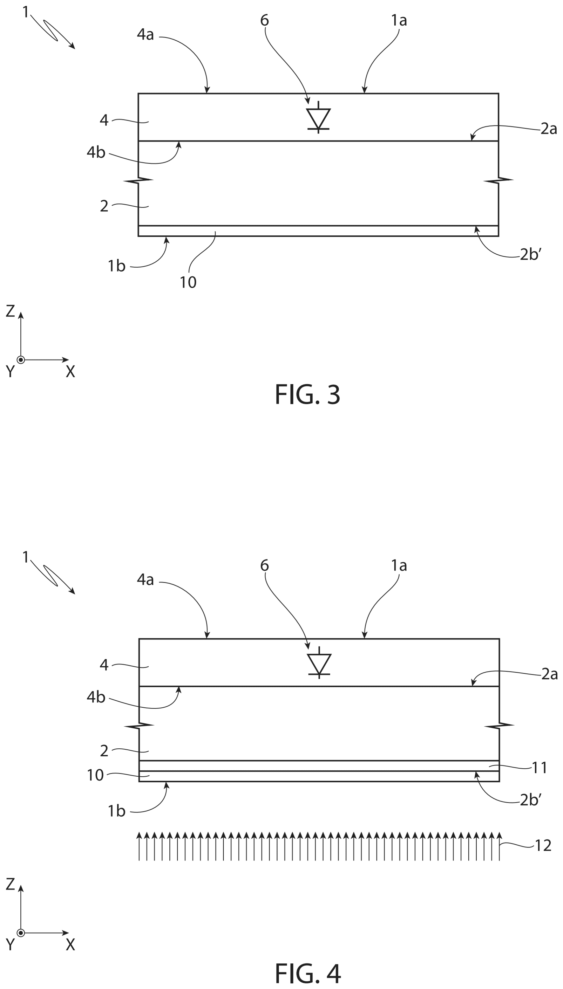

With reference to Figure 3, a deposition step of a first metal layer 10 is carried out on the back face 1b of the wafer 1. In particular, the first metal layer 10 extends in direct physical contact with the lower surface 2b' of the substrate 2.

The first metal layer 10 has a maximum thickness, along the Z-axis, comprised between 10 nm and 50 nm and preferably lower than 30 nm, for example equal to 10 nm.

The first metal layer 10 is of, or includes, titanium (Ti) or nickel (Ni) or molybdenum (Mo) or tungsten (W) or composite materials containing at least one of these metals, for example tungsten carbide (WC) or nickel-vanadium (NiV), or any other metal species that reflects a lower percentage than 50% of the laser radiation or laser beam used in the step of Figure 4 and identified by arrows 12.

With reference to Figure 4, a first thermal treatment step is performed, in particular by laser (laser annealing) and hereinafter referred to as the first laser annealing step, of the first metal layer 10, schematically represented by arrows 12 in Figure 4.

In one embodiment, the first laser annealing step is performed through at least one pulsed laser beam, generated with the following parameters:
- wavelength comprised between 250 nm and 400 nm, in particular 310 nm;
- pulse duration comprised between 100 and 300 ns, in particular 160 ns; and
- number of pulses comprised between 1 and 5, in particular 1.

By means of this laser beam, an energy density comprised between 1 and 5 J/cm², in particular equal to 3 J/cm², is supplied to the first metal layer 10.

The first laser annealing step is performed in such a way as to heat the first metal layer 10 to a temperature comprised between 1200 °C and 2600 °C, in particular equal to 1900 °C.

The energy density supplied to the first metal layer 10 during the first laser annealing step is regulated or adjusted based on the thickness of the first metal layer 10, through the choice of the laser operating parameters.

In particular, the energy density supplied is regulated or adjusted in a manner proportional to the thickness of the first metal layer 10, therefore lower energy density values will correspond to lower thicknesses of the first metal layer 10.

For example, if the first metal layer 10 has a thickness lower than 20 nm, the energy density supplied is lower than or equal to 3.5 J/cm², while if the first metal layer 10 has a thickness greater than 20 nm, the energy density supplied is equal to or greater than 3.5 J/cm².

The first laser annealing step of the first metal layer 10 is adapted to induce a reorganization of the crystal lattice of the 4H-SiC at the interface between the substrate 2 and the first metal layer 10, in particular at the new lower surface 2b' of the substrate 2. This reorganization allows to release the mechanical stress accumulated during the grinding process of the wafer 1, eliminating, in whole or in part, the deformation of the wafer 1, i.e. compensating or correcting the deformation of the wafer 1. In detail, the first metal layer 10 is adapted to redistribute the energy supplied by the laser during the first laser annealing step on the back face 1b of the wafer 1. Furthermore, the lower the thickness of the first metal layer 10, the lower the energy necessary during the first laser annealing step to obtain the reorganization of the crystal lattice of the 4H-SiC forming the substrate 2.

Furthermore, during the first laser annealing step, atoms of the first metal layer 10 diffuse in the substrate 2, and react with silicon atoms of the 4H-SiC of the substrate 2, forming a first silicide layer 11, for example of titanium silicide (TiSi), or nickel silicide (NiSi), or molybdenum silicide (MoSi), or tungsten silicide (WSi), which extends in the substrate 2 at the new lower surface 2b' of the substrate 2, in direct physical contact with the first metal layer 10.

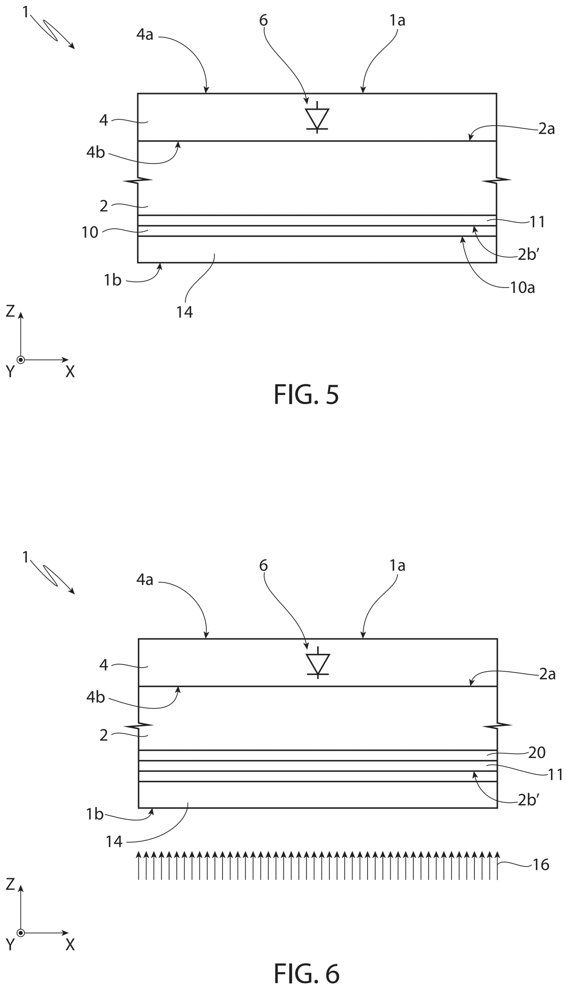

With reference to Figure 5, a deposition step of a second metal layer 14 is then carried out on the surface 10a (opposite along the Z-axis with respect to the surface 2b') of the first metal layer 10.

The second metal layer 14 has a maximum thickness along the Z-axis comprised between 10 nm and 100 nm, in particular equal to 50 nm. In particular, the thickness of the second metal layer 14 is greater than the thickness of the first metal layer 10.

The second metal layer 14 is of a metal adapted to form an ohmic contact with the substrate 2 through the first metal layer 10, for example it is of, or includes, titanium (Ti) or nickel (Ni) or composite materials containing at least one of these metals, for example nickel-vanadium (NiV).

The first metal layer 10 is therefore interposed between the second metal layer 14 and the substrate 2, and is in direct physical and electrical contact with the second metal layer 14 and in electrical contact with the substrate 2.

With reference to Figure 6, a second thermal treatment step is then performed, in particular by laser and hereinafter referred to as the second laser annealing step, of the second metal layer 14, schematically represented by arrows 16 in Figure 6.

The second laser annealing step is performed through at least one pulsed laser beam, generated with the following parameters:
- wavelength comprised between 290 nm and 370 nm, in particular equal to 310 nm;
- pulse duration comprised between 100 and 300 ns, in particular equal to 160 ns;
- number of pulses comprised between 1 and 10, in particular equal to 1.

By means of this laser beam, an energy density comprised between 2 and 5 J/cm², in particular equal to 4 J/cm², is supplied to the second metal layer 14.

The second laser annealing step is performed in such a way as to heat the second metal layer 14 to a temperature comprised between 1400 °C and 2600 °C, in particular equal to 2000 °C.

The energy density supplied to the second metal layer 14 during the second laser annealing step 16 is regulated or adjusted based on the thickness of the second metal layer 14, through the choice of the laser operating parameters.

In particular, the energy density supplied is regulated or adjusted in a manner proportional to the thickness of the second metal layer 14, therefore lower energy density values will correspond to lower thicknesses of the second metal layer 10.

For example, if the second metal layer 14 has a thickness lower than 50 nm, the energy density supplied is lower than or equal to 4 J/cm²; if the second metal layer 14 has a thickness greater than 50 nm, the energy density supplied is equal to or greater than 4 J/cm².

The second laser annealing step is adapted to favour the formation of the ohmic contact between the second metal layer 14 and the substrate 2.

In particular, during the second laser annealing step, atoms of the second metal layer 14 diffuse in the substrate 2 more in depth than the first silicide layer 11, and react with silicon atoms of the 4H-SiC of the substrate 2, forming a second silicide layer (hereinafter also referred to as the "ohmic contact region") 20.

The second silicide layer 20 is for example of titanium silicide (TiSi), or nickel silicide (NiSi), and extends in the substrate 2, in direct physical contact with the first silicide layer 11 and in electrical contact with the first metal layer 10 through the first silicide layer 11.

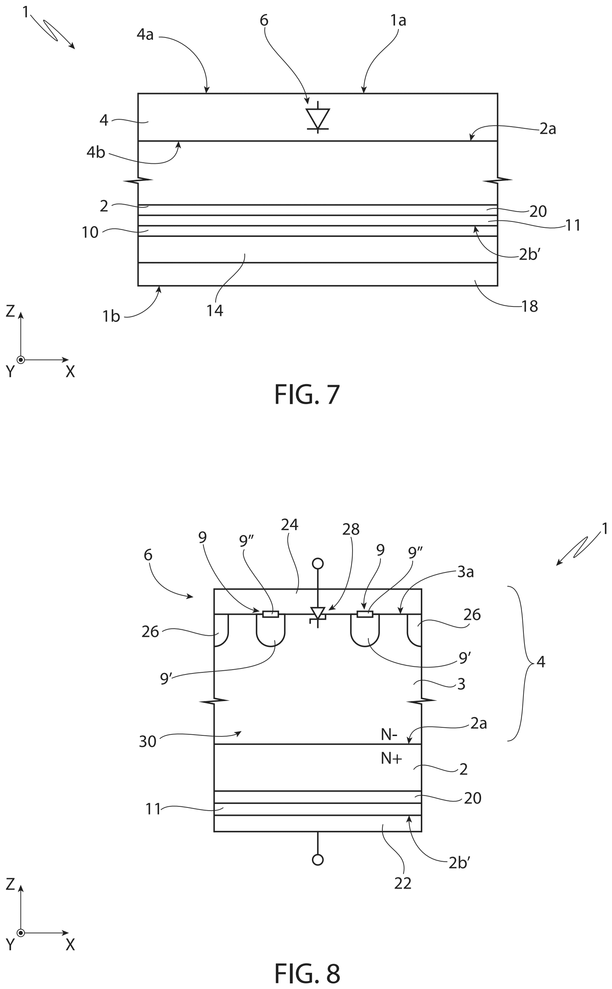

With reference to Figure 7, an optional deposition step of a finishing layer 18 is then carried out on the exposed surface of the second metal layer 14.

The finishing layer 18 includes, for example, superimposed layers of titanium, nickel and gold (Ti/Ni/Au) or titanium, nickel and silver (Ti/Ni/Ag) and is adapted to be coupled with external polarization elements (e.g. by soldering) to provide, in use, a polarization to the substrate 2.

Figure 8 shows in an exemplary manner and without introducing limitations, the electronic device 6 accommodated on the wafer 1. In particular, the electronic device 6 illustrated in Figure 8 is of the merged-PN-Schottky (MPS) type, and is hereinafter referred to as the MPS device 6. Figure 8 is represented in cross-section on the XZ plane.

The MPS device 6 includes: the substrate 2, of N-type 4H-SiC, having a first dopant concentration, provided with the upper surface 2a opposite to the lower surface 2b', and a thickness equal to about 100 µm; a(n) (epitaxially grown) drift layer 3, of N-type SiC, having a second dopant concentration lower than the first dopant concentration, which extends on the upper surface 2a of the substrate 2, and a thickness comprised between 5 and 10 µm; the first silicide layer 11 which extends in the substrate 2 at the lower surface 2b' of the substrate 2; the ohmic contact region 20, which extends in the substrate 2 in electrical contact with the first metal layer 10 through the first silicide layer 11; a cathode metallization 22, which extends on the ohmic contact region 20. The cathode metallization 22 includes, although not illustrated in Figure 8, the first metal layer 10, the second metal layer 14 and, optionally, the finishing layer 18.

The MPS device 6 further includes an anode metallization 24 which extends on an upper surface 3a of the drift layer 3; multiple Junction-Barrier (JB) elements 9 in the drift layer 3, facing the upper surface 3a of the drift layer 3 and each including a respective implanted region 9' of the P-type and an ohmic contact 9" of metal material; and an edge termination region, or protection ring, 26 (optional), in particular a P-type implanted region, which completely surrounds the junction-barrier (JB) elements 9.

Schottky diodes 28 are formed at the interface between the drift layer 3 and the anode metallization 24. In particular, Schottky (semiconductor-metal) junctions are formed by portions of the drift layer 3 in direct electrical contact with respective portions of the anode metallization 24.

The region of the MPS device 6 which includes the JB elements 9 and the Schottky diodes 28 (i.e., the region contained within the protection ring 26) is an active area 30 of the MPS device 6.

The drift layer 3, the anode metallization 24, the junction barrier (JB) elements 9 and the protection ring 26 form the layer stack 4.

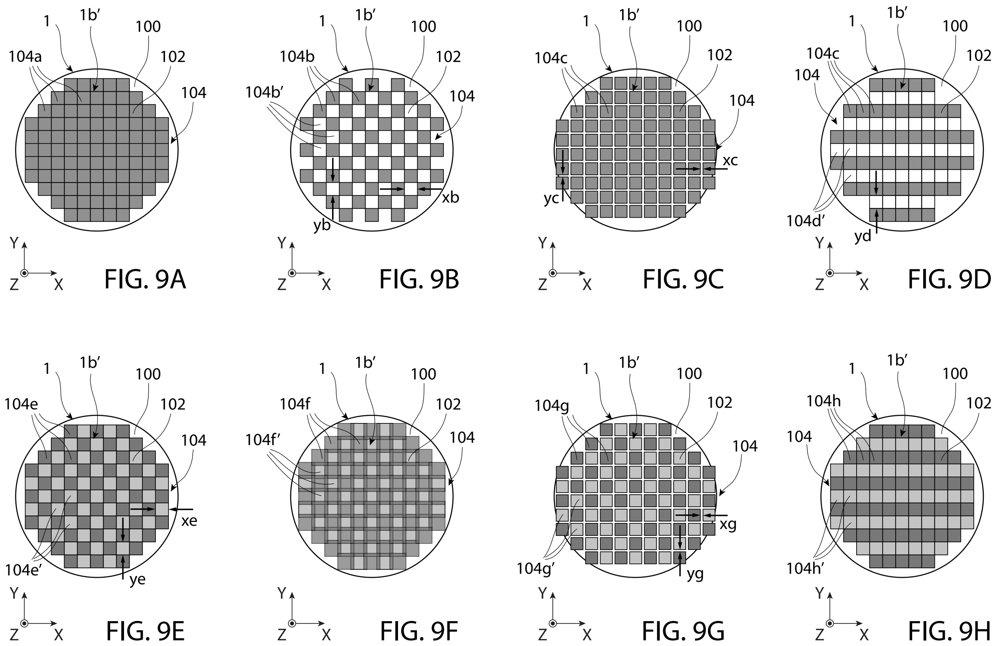

Figures 9A-9H illustrate respective laser annealing patterns applied to the first metal layer 10 during the first laser annealing step (Figure 4), according to a further embodiment. In this embodiment, the energy density is supplied to the metal layer 10 in a non-uniform manner.

With reference to any of Figures 9A-9H, the back face 1b includes an edge region 100 and a central region 102. In view on the XY plane, the central region 102 comprises and surrounds the electronic devices 6 (accommodated at the front face 1a of the wafer 1). The edge region 100 extends on the XY plane surrounding, at least in part, the central region 102. In other words, the central region 102 is the region of the wafer 1 usable for manufacturing electronic devices and, subsequently, used and usable for dicing the wafer 1.

In particular, the patterns of Figures 9A-9H envisage that the edge region 100 is not irradiated by any laser beam. The patterns of Figures 9A-9H also envisage that the central region 102 is divided, in order to provide the laser radiation for annealing, into a grid or matrix 104 formed by a plurality of cells which extend on the XY plane, for example each cell having a square shape.

The patterns of Figures 9A-9D are now described, which envisage to irradiate with a laser beam selective portions of the region 102, thus supplying a respective energy density selectively to the sole irradiated portions. During the laser annealing step, the laser beam is generated according to what has already been described with reference to Figure 4, for example with the following parameters:
- wavelength comprised between 250 nm and 400 nm, in particular 310 nm;
- pulse duration comprised between 100 and 300 ns, in particular 160 ns; and
- number of pulses comprised between 1 and 5, in particular 1.

By means of this laser beam, an energy density comprised between 1 and 5 J/cm², in particular equal to 3 J/cm², is supplied to the first metal layer 10.

With reference to Figure 9A, the grid 104 contains a plurality of cells 104a, here exemplarily of square shape, wherein each cell 104a extends in contact with its nearest-neighbor cells 104a along the X-axis and along the Y-axis. Each cell 104a receives the first energy density by means of the laser beam. In other words, the entire central region 102 receives the first energy density by means of the laser beam.

According to Figure 9B, the grid 104 contains a plurality of cells 104b exemplarily of square shape which receive the first energy density by means of the laser beam, and a plurality of square cells 104b' which do not receive the first energy density. The cells 104b and 104b' extend respectively alternated to each other along the X-axis and along the Y-axis, such that each cell 104b is in contact with the respective nearest-neighbor cells 104b' along the X-axis and is in contact with the respective nearest-neighbor cells 104b' along the Y-axis.

In other words, each cell 104b extends at a distance from its nearest-neighbor cells 104b along the X-axis, at a distance from its nearest-neighbor cells 104b along the Y-axis, and in contact with its nearest-neighbor cells 104b along directions diagonal with respect to the axes X and Y. In particular, a distance xb along the X-axis between nearest-neighbor cells 104b is comprised between 1 mm and 30 mm; a distance yb along the Y-axis between nearest-neighbor cells 104b is comprised between 1 mm and 30 mm. The distances xb and yb are, for example, equal to respective extensions of the cells 104b' along the X-axis and along the Y-axis, respectively.

According to Figure 9C, the grid 104 contains a plurality of cells 104c, exemplarily of square shape. Each cell 104c extends at a distance xc from its nearest-neighbor cells 104c along the X-axis. The distance xc is comprised for example between 1 mm and 30 mm. Each cell 104c extends at a distance yc from its nearest-neighbor cells 104c along the Y-axis. The distance yc is comprised between 1 mm and 30 mm. Each cell 104c receives the first energy density by means of the laser beam.

According to Figure 9D, the grid 104 contains a plurality of cells 104d exemplarily of square shape. Each cell 104d extends in contact with its nearest-neighbor cells 104d along the X-axis. Each cell 104d extends at a distance yd from its nearest-neighbor cells 104d along the Y-axis. The distance yd is comprised for example between 1 mm and 30 mm and is equal to, for example, one extension along the Y-axis of a cell 104d. Each cell 104d receives the first energy density by means of the laser beam. In other words, the grid 104 contains a plurality of cells 104d, exemplarily of square shape, which receive the first energy density by means of the laser beam, and a plurality of cells 104d', exemplarily of square shape, which do not receive the first energy density. The cells 104d and 104d' extend respectively alternated to each other along the Y-axis. The cells 104d extend along the X-axis adjacent to respective nearest-neighbor cells 104d. The cells 104d' extend along the X-axis adjacent to respective nearest-neighbor cells 104d'. In other words, in grid 104 of Figure 9D, the cells 104d extend to form a plurality of rows parallel to the X-axis; similarly, the cells 104d' also extend to form a plurality of rows parallel to the X-axis. The rows formed by the cells 104d are alternated, along the Y-axis, with the rows formed by the cells 104d'.

With reference to Figures 9E-9H, respective annealing patterns are now described which envisage to provide a first set of selective portions of the central region 102 with a first energy density and a second set of selective portions of the central region 102 with a second energy density, by means of respective first and second laser beams.

The first laser beam is generated using a first set of parameters:
- wavelength comprised between 250 nm and 400 nm;
- pulse duration comprised between 100 and 300 ns; and
- number of pulses comprised between 1 and 5.

By means of this first laser beam, a first energy density comprised between 1 and 5 J/cm², in particular equal to 3 J/cm², is supplied to the first metal layer 10.

The second laser beam is generated using a second set of parameters:
- wavelength comprised between 250 nm and 400 nm;
- pulse duration comprised between 100 and 300 ns; and
- number of pulses comprised between 1 and 5.

By means of this second laser beam, a second energy density comprised between 1 and 5 J/cm², in particular equal to 3 J/cm², is supplied to the first metal layer 10.

It is noted that at least one of the parameters of the second laser beam (i.e. at least one of wavelength, pulse duration and number of pulses) is different from the corresponding parameter of the first laser beam. Consequently, the first energy density is different from the second energy density.

With reference to Figure 9E, the grid 104 contains a plurality of cells 104e, exemplarily of square shape, which receive the first energy density supplied by the first laser beam, and a plurality of cells 104e', exemplarily of square shape, which receive the second energy density supplied by the second laser beam. The cells 104e and 104e' extend respectively alternated to each other along the X-axis and along the Y-axis, such that each cell 104e is in contact with the respective nearest-neighbor cells 104e' along the X-axis and along the Y-axis.

In other words, according to Figure 9E, each cell 104e extends at a distance from its nearest-neighbor cells 104e along the X-axis, at a distance from its nearest-neighbor cells 104e along the Y-axis, and in contact with its nearest-neighbor cells 104e along directions diagonal with respect to the axes X and Y. In particular, a distance xe along the X-axis between nearest-neighbor cells 104e is comprised between 1 mm and 30 mm; a distance ye along the Y-axis between nearest-neighbor cells 104e is comprised between 1 mm and 30 mm. The distances xe and ye are, for example, equal to respective extensions of the cells 104e' along the X-axis and along the Y-axis, respectively.

According to Figure 9F, the grid 104 contains a plurality of cells 104f, exemplarily of square shape, which receive the first energy density supplied by the first laser beam, and a plurality of cells 104f', exemplarily of square shape, which receive the second energy density supplied by the second laser beam. The cells 104f and 104f' extend respectively alternated to each other along the X-axis and along the Y-axis, and such that each cell 104f extends superimposing in part on the respective nearest-neighbor cells 104f' along the X-axis and/or along the Y-axis.

According to Figure 9G, the grid 104 contains a plurality of cells 104g, exemplarily square, which receive the first energy density supplied by the first laser beam, and a plurality of cells 104g', exemplarily square, which receive the second energy density supplied by the second laser beam. Each cell 104g extends at a distance xg from its nearest-neighbor cells 104g' along the X-axis. The distance xg is comprised, for example, between 1 mm and 30 mm. Each cell 104g extends at a distance yg from its nearest-neighbor cells 104g' along the Y-axis. The distance yg is comprised, for example, between 1 mm and 30 mm.

According to Figure 9H, the grid 104 contains a plurality of cells 104h, exemplarily square, which receive the first energy density supplied by the first laser beam, and a plurality of cells 104h', exemplarily square, which receive the second energy density supplied by the second laser beam. The cells 104h and 104h' extend respectively alternated to each other along the Y-axis, such that each cell 104h is adjacent to the respective nearest-neighbor cells 104h along the X-axis, and each cell 104h is adjacent to the respective nearest-neighbor cells 104h' along the Y-axis. In other words, in the grid 104 of Figure 9H, the cells 104h extend to form a plurality of rows parallel to the X-axis; similarly, the cells 104h' also extend to form a plurality of rows parallel to the X-axis. The rows formed by the cells 104h are alternated, along the Y-axis, to the rows formed by the cells 104h'.

Summarizing the above, the first laser annealing step 12 comprises heating, by means of a first laser beam, a first set of portions of the first metal layer 10 respectively. Said first set of portions being chosen from among a plurality of portions 104 of the first metal layer 10 which extend according to a matrix-type pattern having rows along the X-axis and columns along the Y-axis.

In one embodiment, the plurality of portions 104 comprises first portions 104b; 104d; 104e; 104f; 104g; 104h and second portions 104b'; 104d'; 104e'; 104f'; 104g'; 104h' which extend alternated to each other along the Y-axis, and wherein the first set of portions comprises first portions 104b; 104d; 104e; 104f; 104g; 104h.

In one embodiment, the first portions 104b; 104e; 104f; 104g and the second portions 104b'; 104d'; 104e'; 104f'; 104g' extend alternated to each other along the X-axis.

In a further embodiment, the first laser annealing step further comprises heating, by means of a second laser beam, a second set of portions among the plurality of portions 104, the second set of portions being different from the first set of portions.

In one embodiment, the second set of portions comprises the second portions 104e'; 104f'; 104g'; 104h'.

In one embodiment, the first set of portions coincides with said plurality of portions 104.

In one embodiment, the portions of the plurality of portions 104 extend adjacent to respective nearest neighbours portions along the X-axis and along the Y-axis.

In an alternative embodiment, the portions of the plurality of portions 104 extend at a distance from respective nearest neighbours portions along the X-axis and along the Y-axis.

In a further embodiment, the portions of the plurality of portions 104 extend superimposed in part on respective nearest neighbours portions along the X-axis and along the Y-axis.

According to a further embodiment, what has been described with reference to Figures 9A-9H also applies similarly to the laser annealing step of Figure 6 (identified by arrows 16), and using the laser control parameters described with reference to such Figure.

It is noted that, when the metal layer 14 is processed according to the embodiments of Figures 9E-9H, the laser annealing parameters are chosen such that the first laser beam is generated using at least one parameter other than the second laser beam.

Finally, it is clear that modifications and variations may be made to what has been described and illustrated herein without thereby departing from the scope of the present invention, as defined in the attached claims.

For example, although the device 6 has been described with reference to an MPS device, the present invention may equally be applied without limitations to other typologies of electronic devices, such as for example MOSFETs or IGBTs.

Furthermore, although the patterns of Figures 9A-9H have been described with reference to a grid 104 which includes a plurality of square cells, other grids are possible, which include for example rectangular or polygonal cells in general.

Furthermore, the first and second laser annealing steps may be carried out by a single pass of each laser beam on the back face 1b of the wafer 1, or by means of more than one pass of each laser beam, respectively.

In the light of what has been previously exposed, the advantages that the present invention affords are evident.

In particular, the proposed solution allows to mitigate or completely eliminate the deformations of the wafer 1 resulting from the grinding step. In other words, the proposed solution allows to compensate the deformation of the wafer 1. The implementation of such a manufacturing method may lead to a drastic increase in the yield of the manufacturing processes, to a decrease in the breakdowns of the 4H-SiC wafers, and to an increase in the quality of the devices.

In particular, the local heating due to the first laser annealing step of the metal-4H-SiC interface on the new back surface 1b of the wafer 1, facilitates the reordering of the crystal lattice of the 4H-SiC, with consequent reduction in the stresses and deformation of the wafer 1. This process contributes to restoring the structural integrity of the wafer 1, improving its suitability for the subsequent manufacturing steps.

Furthermore, by distributing the energy density supplied by the laser beams in a non-uniform manner on the back face 1b of the wafer 1, the value of energy density supplied in selective zones of the back face 1b of the wafer 1 may be further reduced, further reducing the risk of forming cracks in the substrate 2.

## Claims

1. A method of manufacturing an electronic device, comprising the steps of:
- providing a substrate (2) of silicon carbide, in particular 4H-SiC, having a first surface (2a) and a second surface (2b') opposite to the first surface (2a) along a first direction (Z);
- depositing, on the second surface (2b') a first metal layer (10) having a first thickness;
- heating selective portions of the first metal layer (10) by means of a first laser beam (12);
- depositing, in direct physical contact with the first metal layer (10), a second metal layer (14) having a second thickness greater than the first thickness; and
- heating selective portions of the second metal layer (14) by means of a second laser beam (16).

2. The method according to claim 1, wherein the first thickness is equal to, or lower than, 50 nm, in particular equal to, or lower than, 10 nm.

3. The method according to claim 1 or 2, wherein the first metal layer (10) is of, or includes, at least one of: titanium, nickel, molybdenum, tungsten.

4. The method according to any of the preceding claims, wherein heating selective portions of the first metal layer (10) comprises generating the first laser beam (12) with the following parameters:
- wavelength comprised between 250 nm and 400 nm, in particular equal to 310 nm;
- pulse duration comprised between 100 and 300 ns, in particular equal to 160 ns;
- number of pulses comprised between 1 and 5, in particular equal to 1.

5. The method according to any of the preceding claims, wherein heating selective portions of the second metal layer (14) comprises generating the second laser beam (16) with the following parameters:
- wavelength comprised between 290 nm and 370 nm, in particular equal to 310 nm;
- pulse duration comprised between 100 and 300 ns, in particular equal to 160 ns;
- number of pulses comprised between 1 and 10, in particular equal to 2.

6. The method according to any of the preceding claims, wherein heating selective portions of the first metal layer (10) comprises supplying, to the first metal layer (10) through the first laser beam (12), an energy density comprised between 1 and 5 J/cm².

7. The method according to any of the preceding claims, wherein heating selective portions of the second metal layer (14) comprises supplying, to the second metal layer (14) through the second laser beam (16), an energy density comprised between 2 and 5 J/cm².

8. The method according to any of the preceding claims, wherein the wafer (1) accommodates, at the first surface (2a) of the substrate (2), at least one electronic device, in particular one of a JB diode and a Schottky diode.

9. The method according to any of the preceding claims, wherein the substrate (2) has a maximum thickness, between the first surface (2a) and the second surface (2b'), equal to or lower than 100 um.

10. The method according to any of the preceding claims, wherein the step of heating selective portions of the first metal layer (10) by means of the first laser beam (12) comprises:
heating, by means of the first laser beam, a first set of portions of the first metal layer (10) at a surface (10a) of the first metal layer (10), said first set of portions being chosen from among a plurality of portions (104) of the first metal layer (10) which extend, at the surface (10a) of the first metal layer (10), according to a matrix-type pattern having rows along a second direction (X) orthogonal to the first direction (Z) and columns along a third direction (Y) transverse to the second direction (X) and orthogonal to the first direction (Z).

11. The method according to claim 10, further comprising heating, by means of a third laser beam, a second set of portions among the plurality of portions (104), the second set of portions being different from the first set of portions.

12. An electronic device, comprising:
- a substrate (2) of silicon carbide, in particular of the 4H-SiC polytype, having a first surface (2a) and a second surface (2b') opposite to the first surface (2a);
- a first metal layer (10), extending on, and in electrical contact with, the second surface (2b') of the substrate (2);
- a second metal layer (14), extending on, and in direct physical contact with, the first metal layer (10),
wherein the first metal layer (10) has a first thickness and the second metal layer (14) has a second thickness greater than the first thickness.

13. The electronic device according to claim 12, further comprising a first silicide layer (11) extending at the second surface (2b') of the substrate (2) below the first metal layer (10) and in electrical contact with the first metal layer (10), wherein said first silicide layer (11) extends in a first set of portions selected from a plurality of portions (104) extending in a matrix-like pattern, said matrix having rows along a second direction (X) orthogonal to the first direction (Z) and columns along a third direction (Y) transverse to the second direction (X) and orthogonal to the first direction (Z).

14. The electronic device according to claim 12 or 13, wherein the first thickness is equal to, or lower than, 50 nm, in particular equal to, or lower than, 10 nm.

15. The electronic device according to anyone of claims 12-14, further comprising a second silicide layer (20) extending in the substrate (2), in direct physical contact with the first silicide layer (11) and in electrical contact with the first metal layer (10),
wherein the first silicide layer (11) is one of: titanium silicide, nickel silicide, molybdenum silicide, tungsten silicide, and wherein the second silicide layer (20) is one of: titanium silicide, nickel silicide.
